# DEMANDE DE BREVET EUROPEEN

(11) **EP 2 302 790 A1**
(43) Date de publication de la demande: **30.03.2011**
(21) Numéro de dépôt: 10176054.4
(22) Date de dépôt: 09.09.2010
(51) Int. Cl.: H03F 3/30

(54) **Etage de sortie d'un amplificateur classe A**

(30) Priorité: 17.09.2009 FR 0956407
(71) Demandeur: STMicroelectronics (Grenoble 2) SAS, 38000 Grenoble (FR)
(72) Inventeur: Forel, Christophe, 38000 Grenoble (FR); Mazet, Roland, 38640 Claix (FR)
(74) Mandataire: de Beaumont, Michel

(57) **Abrégé**

L'invention concerne un étage de sortie d'un amplificateur classe A intégré dans une technologie adaptée à une première tension (V₁) et destiné à être alimenté sous une deuxième tension (V₂) supérieure à la première, comportant : un ou plusieurs transistors (P41, DP42) d'un premier type de canal (P) entre une première borne (8) d'application de la deuxième tension et une borne (9) de sortie de l'étage ; des transistors (N25, N31, N32, N33) d'un deuxième type de canal (N) entre cette borne de sortie (9) et une deuxième borne (7) d'application de la deuxième tension, dans lequel : un premier transistor (N25) du deuxième type de canal a sa grille directement connectée à une borne (24) d'entrée de l'étage ; au moins un deuxième (N31) et un troisième (N32) transistors du deuxième type de canal sont en série entre la borne de sortie et ledit premier transistor, la grille du deuxième transistor étant connectée au point milieu d'un pont diviseur résistif (R1, R2) entre ladite borne de sortie et la grille du troisième transistor, et la grille du troisième transistor étant polarisée à un potentiel fixe (V_{G32}).

## Description

### Domaine de l'invention

La présente invention concerne de façon générale les circuits électroniques et, plus particulièrement, les amplificateurs dits classe A.

L'invention s'applique plus particulièrement aux chaînes de traitement de signaux audio ou audio/vidéo.

### Exposé de l'art antérieur

Dans la plupart des appareils audio ou audio/vidéo, des signaux, reçus par une antenne, extraits d'une cassette, d'un CD/DVD, etc. sont, le cas échéant après retraitement, amplifiés pour être exploités par un dispositif de restitution (téléviseur, home-cinéma, etc.) équipé d'un décodeur. Le plus souvent, ces signaux transitent d'un appareil à un autre par des prises PERITEL en respectant des niveaux fixés par des normes ou sont, à l'intérieur d'un appareil, véhiculés en respectant les niveaux prévus par ces normes. Pour les signaux audio, une norme DOLBY fixe l'excursion maximale des signaux audio à 2 volts RMS (environ 5,6 volts crête à crête).

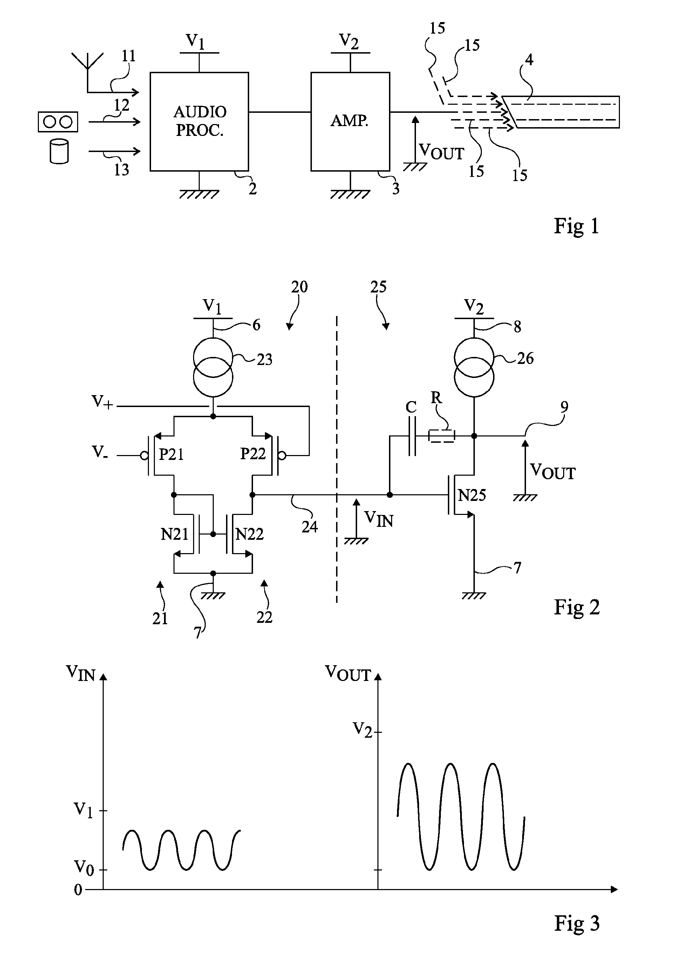

La figure 1 est une représentation schématique d'une chaîne de traitement du type auquel s'applique à titre d'exemple la présente invention.

Dans cet exemple, des signaux audio provenant d'une antenne 11, d'une cassette vidéo 12 ou d'un système numérique 13 sont traités par un ou plusieurs circuits 2 (AUDIO PROC.) avant d'être amplifiés (bloc 3, AMP.) pour être fournis à une prise PERITEL 4. Les traitements (démodulation, filtrage, séparation de voies, etc.) opérés par les circuits 2 sont différents selon la source audio mais le ou les signaux fournis par le circuit 2 doivent tous être amplifiés pour respecter en sortie la norme DOLBY. D'autres signaux audio ou vidéo arrivent sur la prise PERITEL 4 (flèches en pointillé 15). Ces signaux proviennent de voies de traitement parallèles. En particulier pour des signaux stéréo, des voies gauche et droite sont amplifiées séparément (le cas échéant en partageant un même circuit 2 en amont).

Les fonctions de traitement 2 et d'amplification 3 sont généralement réalisées par des circuits alimentés sous des tensions V₁ et V₂ différentes (V₂ étant supérieure à V₁) et réalisés dans des technologies également différentes, c'est-à-dire avec des transistors adaptés à supporter des tensions différentes. En reprenant l'exemple de la norme DOLBY, la tension V₂ est de l'ordre de 8 volts alors que les circuits de traitement sont alimentés sous une tension V₁ inférieure, par exemple, de l'ordre de 3,3 volts. Pour simplifier, on fera par la suite référence à des tensions haute et basse, mais ces tension restent du même ordre de grandeur (il ne s'agit pas de passer d'une basse tension de quelque volts à une haute tension d'une centaine de volts).

Il serait souhaitable de pouvoir intégrer toute la chaîne de traitement dans un même circuit intégré. Toutefois, réaliser ce circuit dans la technologie adaptée à la tension la plus élevée nuit à l'encombrement et engendre une consommation non nécessaire dans la partie traitement.

Il serait donc souhaitable de réaliser l'amplificateur dans la technologie basse tension. Se pose alors le problème que les transistors de cette technologie basse tension ne supportent pas la haute tension requise pour fournir le signal amplifié avec l'excursion de sortie souhaitée.

### Résumé

Un objet d'un mode de réalisation de la présente invention est de proposer un amplificateur classe A, et plus particulièrement un étage de sortie d'un tel amplificateur, dans une technologie dont les transistors supportent une tension inférieure à la tension d'alimentation de l'amplificateur.

Un autre objet d'un mode de réalisation de la présente invention est de proposer une chaîne de traitement et d'amplification de signaux pouvant être intégrée dans une technologie de transistors ne supportant qu'une tension inférieure à une tension d'alimentation de l'étage de sortie de l'amplificateur.

Un autre objet d'un mode de réalisation de la présente invention est de proposer une solution plus particulièrement adaptée à la réalisation d'un amplificateur classe A respectant la norme DOLBY.

Pour atteindre toute ou partie de ces objets ainsi que d'autres, la présente invention prévoit un étage de sortie d'un amplificateur classe A intégré dans une technologie adaptée à une première tension et destiné à être alimenté sous une deuxième tension supérieure à la première, comportant :
un ou plusieurs transistors d'un premier type de canal entre une première borne d'application de la deuxième tension et une borne de sortie de l'étage ;
des transistors d'un deuxième type de canal entre cette borne de sortie et une deuxième borne d'application de la deuxième tension, dans lequel :
   un premier transistor du deuxième type de canal a sa grille directement connectée à une borne d'entrée de l'étage ;
   au moins un deuxième et un troisième transistors du deuxième type de canal sont en série entre la borne de sortie et ledit premier transistor, la grille du deuxième transistor étant connectée au point milieu d'un pont diviseur résistif entre ladite borne de sortie et la grille du troisième transistor, et la grille du troisième transistor étant polarisée à un potentiel fixe.

Selon un mode de réalisation de la présente invention, deux éléments capacitifs en série relient la borne d'entrée à la borne de sortie, un pont diviseur résistif reliant la borne de sortie à la deuxième borne d'application de la deuxième tension et ayant son point milieu relié au point milieu de l'association en série des deux éléments capacitifs.

Selon un mode de réalisation de la présente invention, un quatrième transistor du deuxième type de canal est intercalé entre les premier et troisième transistors.

Selon un mode de réalisation de la présente invention, le ou les transistors du premier type de canal forment une source de courant entre ladite première borne d'application de la deuxième tension et la borne de sortie.

Selon un mode de réalisation de la présente invention, ladite source de courant comporte au moins un premier transistor du premier type de canal, de type DRIFT.

Selon un mode de réalisation de la présente invention, ledit premier transistor du premier type de canal est monté en cascode avec au moins un deuxième transistor du même type.

Selon un mode de réalisation de la présente invention, plusieurs transistors du premier type de canal sont en série entre la première borne d'application de la deuxième tension et la borne de sortie, au moins un de ces transistors ayant sa grille reliée au point milieu d'un pont diviseur résistif connecté entre la grille du transistor voisin de l'association en série et la borne de sortie.

On prévoit également un amplificateur classe A, comportant un tel étage de sortie.

On prévoit également une chaîne de traitement de signaux audio comportant, pour chaque voie, un tel amplificateur classe A.

### Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :
la figure 1 qui a été décrite précédemment représente schématiquement et sous forme de blocs un exemple de chaîne de traitement de signaux audio du type auquel s'applique la présente invention ;
la figure 2 représente un exemple de schéma usuel d'amplificateur classe A ;
la figure 3 illustre la fonction d'amplification souhaitée ;
la figure 4 représente un mode de réalisation d'un amplificateur classe A ;
la figure 5 illustre le fonctionnement de l'étage de sortie de l'amplificateur de la figure 4 ;
la figure 6 représente partiellement une variante de l'étage de sortie de l'amplificateur de la figure 4 ;
la figure 7 représente un mode de réalisation d'un détail du circuit de la figure 4 ; et
la figure 8 représente un mode de réalisation d'un autre détail du circuit de la figure 4.

### Description détaillée

De mêmes éléments ont été désignés par de mêmes références aux différentes figures. Pour des raisons de clarté, seuls les éléments utiles à la compréhension de l'invention ont été représentés et seront décrits. En particulier, l'origine et la destination des signaux traités par l'amplificateur qui va être décrit n'ont pas été détaillées, l'invention étant compatible avec toute application usuelle d'un amplificateur classe A.

La présente invention sera décrite en relation avec un exemple d'application au traitement d'un signal audio analogique. Elle s'applique toutefois plus généralement à tout amplificateur que l'on souhaite réaliser dans une technologie plus fine (dont les transistors supportent une tension plus faible) que celle requise pour l'amplitude des signaux de sortie.

La figure 2 est un schéma simplifié d'un exemple usuel d'amplificateur classe A.

Un étage d'entrée différentiel 20 comporte une source de courant 23, une paire différentielle et une charge active en série entre deux bornes 6 et 7 d'application d'une tension d'alimentation V₁. Chacune de deux branches parallèles 21 et 22 entre la source de courant 23 et la borne 7 comporte un transistor MOS à canal P, respectivement P21, P22, et un transistor MOS à canal N, respectivement N21, N22, en série. Les grilles respectives des transistors P21 et P22 définissent des entrées différentielles V- et V+ de l'amplificateur. Les grilles des transistors N21 et N22 sont reliées au drain du transistor N21 (interconnexion entre les transistors P21 et N21), le transistor N21 étant monté en diode. Les drains interconnectés des transistors P22 et N22 définissent une borne 24 de sortie de l'étage d'entrée 20 à destination d'un étage de sortie 25 ou étage d'amplification de l'amplificateur.

L'étage de sortie 25 comporte un transistor MOS N25, à canal N, en série avec une source de courant 26 entre deux bornes 8 et 7 d'application d'une tension d'alimentation V₂ supérieure à la tension V₁. Le drain du transistor N25 (connecté à la source de courant 26) définit une borne 9 de sortie de l'amplificateur. Un élément capacitif C de stabilisation relie la grille du transistor N25 (donc la borne 24) à son drain (donc à la borne de sortie 9). Le cas échéant, une résistance R (représentée en pointillés) est en série avec le condensateur C et améliore la stabilité de l'amplificateur.

La figure 3 illustre le fonctionnement de l'étage de sortie de l'amplificateur de la figure 2. En supposant l'application d'un signal sinusoïdal entre les entrées V+ et V-, l'étage d'entrée 20 fournit un signal V_{IN} sinusoïdal entre un niveau V₀ et le niveau V₁ (diminué des chutes de tension dans les transistors de la source de courant 23 et des transistors P21 et P22). Le niveau V₀ correspond à la chute de tension grille-source du transistor N21. Le signal V_{IN} est amplifié par l'étage 25 qui fournit un signal sinusoïdal V_{OUT} entre le niveau V₀ et un niveau légèrement inférieur au niveau V₂ (chute de tension dans la source de courant 26). Le fonctionnement d'un amplificateur classe A est connu.

Pour intégrer un tel amplificateur, la solution usuelle est d'utiliser une technologie adaptée à la tension V₂ la plus élevée. Les étages 20 et 25 sont alors réalisés dans cette technologie tout en étant alimentés par des tensions différentes.

Pour intégrer l'amplificateur avec les circuits amont (circuits de traitement 2, figure 1), utiliser la technologie adaptée à la tension V₂ conduit à un encombrement trop important et accroit la consommation.

A l'inverse, les modes de réalisation de la présente invention qui vont être décrits adaptent l'étage de sortie de l'amplificateur pour qu'il puisse être réalisé dans une technologie adaptée à la tension V₁, tout en étant alimenté avec une tension V₂ supérieure.

Pour simplifier la description qui va suivre, on ne fera plus référence aux circuits présents en amont de l'amplificateur et on considérera l'étage d'entrée 20 comme symbolisant ces circuits amont. En effet, cet étage d'entrée est, comme ces circuits amont, alimenté avec la tension de niveau inférieur. En réalité, l'étage d'entrée fait partie de l'amplificateur.

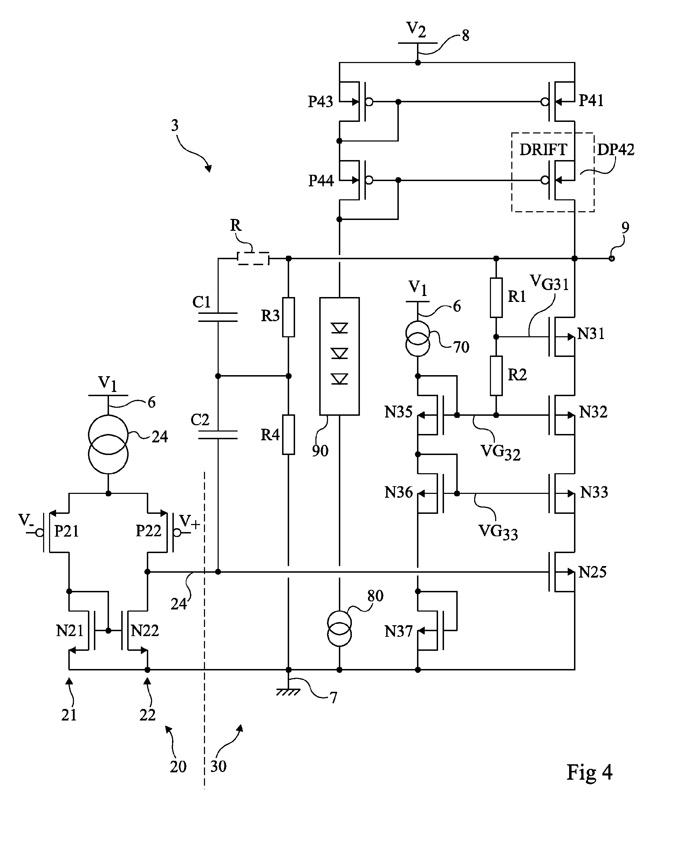

La figure 4 représente un mode de réalisation d'un amplificateur 3 dont l'étage de sortie 30 est destiné à être alimenté sous une tension V₂ tout en étant réalisé dans une technologie adaptée à une tension V₁ inférieure. Par exemple, la tension V₁ est de l'ordre de 3,3 volts et la tension V₂ est de l'ordre de 8 volts.

L'étage d'entrée 20 de l'amplificateur 3 n'est pas modifié par rapport aux étages d'entrée usuels. Il correspond par exemple à l'étage d'entrée 20 décrit en relation avec la figure 2.

Côté étage de sortie, le schéma électrique est modifié pour faire en sorte que tous les transistors soient réalisables dans la technologie adaptée à la tension V₁. Pour cela, on prévoit, au moins dans la partie basse de l'amplificateur (entre la borne de sortie 9 et la masse 7), qu'aucun des transistors de la partie basse ne voit à ses bornes une tension supérieure à la tension acceptable pour la technologie, en particulier lorsque la borne de sortie 9 est au niveau maximum.

Dans l'exemple de la figure 4, trois transistors MOS N31, N32 et N33, à canal N, sont en série entre la borne 9 et le drain du transistor N25 dont la source est à la masse 7. Un même nombre de transistors MOS N35, N36 et N37, à canal N, est connecté en série entre une source de courant 70 et la masse, la source de courant 70 étant, par exemple, connectée à la borne 6 d'application de la tension V₁. Les transistors N35, N36 et N37 sont montés en diode (grille et drain interconnectés). Le transistor N37 compense la tension grille-source du transistor N25, elle-même fixée par l'étage d'entrée 20. Les grilles des transistors N36 et N33 sont interconnectées de même que les grilles des transistors N32 et N35. Il en résulte que les transistors N25, N32 et N33 ne voient à leurs bornes (entre drain et source) qu'une tension grille-source. Cette tension grille-source V_{GS} (par exemple, environ 0,5 volt) est fixée par la source de courant 70 qui fixe les tensions aux bornes des transistors N35, N36 et N37 montés en diode, donc les potentiels V_{G32} et V_{G33} des grilles des transistors N32 et N33. Le potentiel V_{G33} correspond à 2V_{GS} et le potentiel V_{G32} correspond à ^{3V}GS.

Pour limiter la tension aux bornes du transistor N31, un pont diviseur résistif (résistances R1 et R2 en série) est connecté entre la borne 9 et la grille du transistor N32, le point milieu de ce pont diviseur étant connecté à la grille du transistor N31. Les valeurs des résistances R1 et R2 sont choisies pour fixer le potentiel V_{G31} de la grille du transistor N31, donc la tension drain-source des transistors N31 et N32. Les résistances R1 et R2 ont donc des fortes valeurs pour que le courant qui circule dans le pont R1-R2 soit le plus faible possible et évite de perturber l'étage de polarisation des grilles V_{G32} et V_{G33} et l'étage de sortie. Le but est de répartir approximativement la différence de potentiel entre la borne 9 (tension de sortie V_{OUT}) et la source du transistor N32, de façon à obtenir des tensions drain-source V_{DS} identiques pour les transistors N31 et N32. La tension drain-source du transistor N32 peut s'écrire : V_{DS32} = V_{R2}+V_{GS32}-V_{GS31}, où V_{R2} représente la chute de tension aux bornes de la résistance R2 et V_{GS31} et V_{GS32} les tensions grille-source respectives des transistors N31 et N32. Comme les tensions grille-source sont égales (fixées par polarisation), V_{DS32} = V_{R2}. D'autre part, la tension drain-source du transistor N31 peut s'écrire : V_{DS31} = V_{R1}+V_{GS31}, où V_{R1} représente la chute de tension aux bornes de la résistance R1. La valeur de résistance R1 sera donc choisie légèrement inférieure à la valeur de la résistance R2.

Dans l'exemple où la tension d'alimentation V₂ est entre deux et trois fois supérieure à la tension V₁ (donc à la tension que peuvent supporter les transistors basse tension), diviser la tension de sortie par deux suffit.

Selon un autre exemple où la tension V₂ serait entre trois et quatre fois supérieure à la tension V₁ (par exemple, une tension V₂ de l'ordre de 12 volts pour une tension V₁ de l'ordre de 3,3 volts), on prévoit deux transistors à canal N en série entre la borne 9 et le transistor N32 et un pont diviseur de trois résistances en série dont les points milieu respectifs attaquent les grilles de ces deux transistors. Ainsi, chacun de ces transistors ne voit qu'un tiers de l'excursion de sortie à ses bornes.

On aurait pu penser utiliser un montage cascode de transistors à canal N usuel entre la borne 9 et le transistor N25. Toutefois, cela conduirait à utiliser un nombre de transistors en série plus important (au moins 6 pour une tension de 8 volts) avec le risque de voir apparaître des problèmes de distorsion pour des signaux de grande amplitude.

Dans le circuit de la figure 4, l'élément capacitif de stabilisation entre la borne 24 et la borne 9 est formé de deux condensateurs C1 et C2 en série. De plus, deux résistances R3 et R4, en série entre la borne 9 et la masse et dont le point milieu est relié au point milieu de l'association en série des condensateurs C1 et C2, forment un pont diviseur pour éviter que chacun des condensateurs C1 ou C2 ne voie à ses bornes une tension trop élevée. Cela permet d'utiliser la technologie adaptée à la tension V₁ pour réaliser les condensateurs qui autrement ne supporterait pas la tension V₂. Le cas échéant, une résistance additionnelle R (représentée en pointillés) est en série avec les condensateurs C1 et C2.

Côté partie haute de l'étage de sortie 30 (entre la borne 8 d'application de la tension V₂ et la borne de sortie 9), la source de courant 26 (figure 2) est remplacée par un montage cascode d'un transistor MOS P41, à canal P, en série avec un transistor DP42, de type DRIFT à canal P. Un tel transistor DP42 est un transistor haute tension réalisé dans une technologie plus basse tension, c'est-à-dire qu'il est capable de tenir une tension supérieure à la tension que tiennent les autres transistors. Par exemple, dans une technologie 3,3 volts (V₁), les transistors DRIFT à canal P tiennent environ 6,5 volts. Le transistor P41 est monté en miroir sur un transistor P43 monté en diode tandis que le transistor DP42 est monté en miroir sur un transistor P44 monté en diode. Les transistors P43 et P44 sont en série avec une source de courant 80 connectée à la masse 7. Pour que les transistors P43, P44 et ceux de la source de courant 80 ne voient pas une tension supérieure à la tension V₁, des diodes ou autres éléments décaleurs de niveau, symbolisés par un circuit 90, sont intercalés entre le transistor P44 et la source de courant 80.

Si la différence de niveau entre les tensions V₁ et V₂ le permet, on peut se contenter du transistor DP42 et éviter le transistor P41 côté niveau haut de l'étage de sortie. Il faut alors que le transistor haute tension (DRIFT) DP42 supporte à lui seul la tension V₂ diminuée de la chute de tension dans les transistors à canal N de la partie basse. Toutefois, dans l'exemple pris d'une technologie à 3,3 volts, le transistor DP42 supporte environ 6,5 volts et le niveau V_{G32} est de l'ordre de 1,5 volt, ce qui rend nécessaire l'adjonction d'un transistor P41 pour abaisser la tension d'une tension grille-source V_{GS}. De façon similaire, pour des tensions d'alimentation supérieures, plusieurs transistors à canal P cascodés pourront être associés dans la partie haute de l'étage pourvu de ne pas engendrer trop de distorsion.

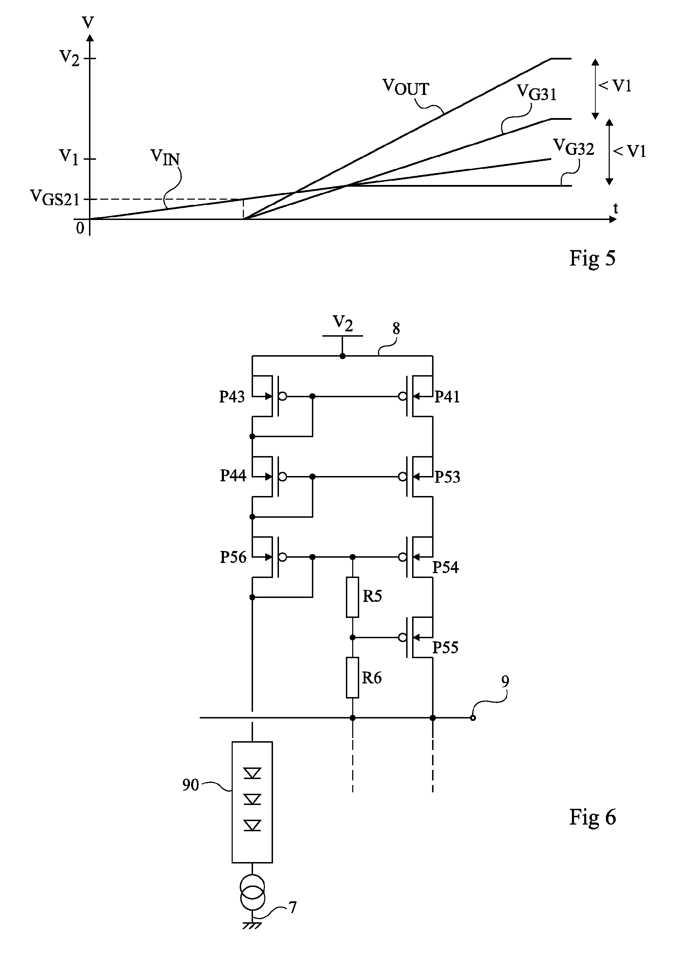

La figure 5 est un chronogramme illustrant le fonctionnement de l'étage de sortie 30 et plus particulièrement de sa partie basse. Ce chronogramme représente les valeurs prises par les tensions V_{G31}, V_{G32} et V_{OUT}. Pour clarifier l'exposé, on suppose un signal V_{IN} sous la forme d'une rampe entre la masse (0) et le niveau de tension V₁. On rappelle toutefois qu'en pratique, le signal est un signal analogique variable (par exemple un signal sinusoïdal ou pseudosinusoïdal).

Les tensions V_{G31}, V_{G32} et V_{OUT} commencent à croître à partir du moment où la tension V_{IN} atteint la tension grille-source V_{GS21} du transistor N21 de l'étage d'entrée. On notera que la figure 5 est une figure théorique. En pratique, le niveau V_{IN} ne pourra jamais être en dessous du niveau V_{GS21} sauf lorsque l'amplificateur est éteint. A partir du niveau V_{GS21}, les tensions V_{G31} et V_{OUT} croissent de façon linéaire (proportionnellement à la tension V_{IN}) avec le rapport d'amplification fixé par les dimensions des transistors et leur polarisation. Dès que le niveau V_{IN} atteint une valeur correspondant au niveau fixé par la polarisation des transistors N32 et N33 (trois fois une tension grille source - 3V_{GS}), la tension V_{G32} est stable à ce niveau.

En prenant pour référence le niveau V_{U32}, la tension V_{G31} correspond approximativement à la moitié de la tension V_{OUT} dès que la tension V_{G32} est stable.

Pour simplifier la représentation de la figure 5, on n'a pas tenu compte des chutes de tension par rapport aux niveaux positifs d'alimentation V₁ et V₂ (s'agissant d'un tracé théorique). On voit que la différence entre les niveaux V_{G32} et V_{G31}, et celle entre les niveaux V_{G31} et V_{OUT}, restent toujours inférieures à la tension V₁, c'est-à-dire que les transistors correspondant ne voient jamais une tension supérieure à la tension V₁.

On aurait pu penser utiliser un transistor haute tension à canal N (DMOS à canal N) en partie basse de l'amplificateur. Toutefois, un tel transistor a son caisson (bulk) relié au substrat, donc à la masse 7. Par conséquent, le transistor N25 se retrouverait connecté en cascode et encaisserait approximativement le niveau de sortie diminué d'une tension grille-source. En partie haute, le caisson du transistor DRIFT à canal P est relié à sa source, ce qui rend possible le montage de la figure 4.

Pour faire apparaître que chacun des transistors, y compris son caisson, ne voit pas une tension supérieure, les connexions des caissons respectifs des transistors ont été représentées aux figures de l'étage de sortie. Comme on peut le voir, chaque transistor a son caisson relié à sa source.

La figure 6 représente une variante de la partie haute de l'étage de sortie dans laquelle un montage similaire au montage de la partie basse de la figure 4 est réalisé. Ainsi, trois transistors MOS P53, P54 et P55 à canal P sont connectés en série entre le transistor P41 et la borne 9. Les transistors P41 et P53 sont montés en miroir sur les transistors P43 et P44 montés en série et en diode. Le transistor P54 a sa grille reliée à celle d'un transistor P56 à canal P monté en diode entre le drain du transistor P44 et la borne du circuit décaleur 90. Un pont diviseur résistif (résistances R5 et R6 en série) est connecté entre la grille du transistor P54 et la borne 9. Le point milieu de ce pont diviseur résistif est relié à la grille du transistor P55. Le fonctionnement de ce montage se déduit de celui exposé en relation avec la figure 4.

On préférera cependant utiliser un transistor MOS à canal P haute tension (mode de réalisation de la figure 4) car il occupe moins de surface que trois transistors (P53 à P55) et le transistor supplémentaire P56 de polarisation.

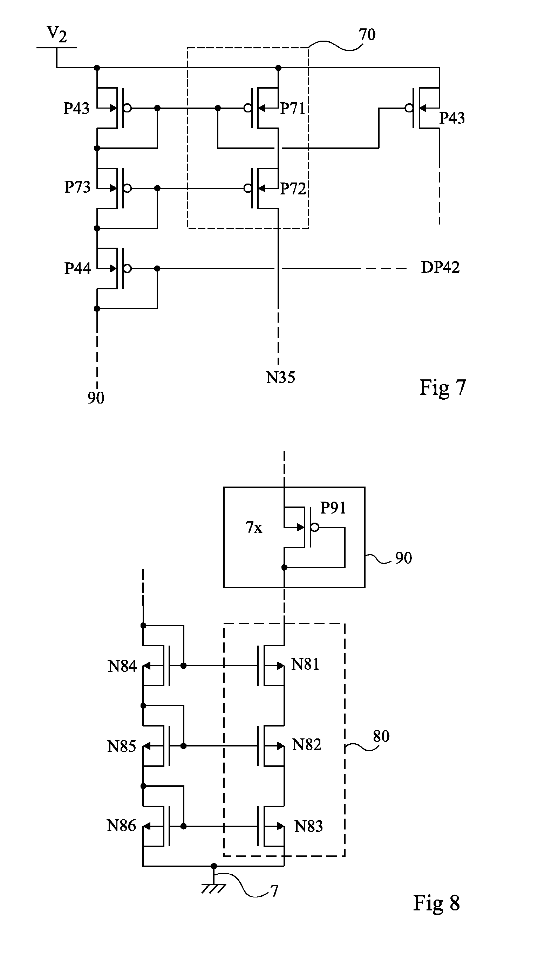

La figure 7 représente un exemple de réalisation de la source de courant 70 de la figure 4 servant à polariser les transistors de la partie basse de l'étage de sortie. Par exemple, on réutilise la source de courant exploitée par la partie haute. Ainsi, un transistor MOS P71 à canal P est monté en miroir sur le transistor P43. Ce transistor est en série avec un autre transistor MOS P72 à canal P dont le drain est relié au drain du transistor N35 (non représenté en figure 7). Un transistor P73 à canal P est intercalé entre les transistors P43 et P44. Ce transistor P73 est monté en diode et a sa grille reliée à celle du transistor P72. Dans cet exemple, la source de courant 70 se trouve alimentée par la tension V₂. Deux transistors en série suffisent grâce au potentiel fixe imposé par les transistors à canal N de la partie basse, car il s'agit d'une branche de polarisation dont les potentiels ne varient pas en fonction du niveau d'entrée.

La figure 8 illustre un exemple de réalisation de la source de courant 80 et du circuit 90.

Le circuit 90 est formé de 7 transistors MOS P91 à canal P montés en diode et en série. En variante, on pourra utiliser de simples diodes ou des éléments résistifs ou tout autre élément décaleur de niveau. La source de courant 80 est formée de trois transistors MOS N81, N82 et N83 à canal N, en série entre la sortie du circuit 90 et la masse 7. Chacun de ces transistors est monté en miroir sur un autre transistor N84, N85 et N86 à canal N. Les transistors N84, N85 et N86 sont en série et en diode entre une source de courant non représentée (au moins un transistor MOS à canal P) de la partie haute et la borne 8 d'application de la tension V₂. Là encore, trois transistors N84 à N86 montés en diode suffisent dans la mesure où il s'agit d'une branche de polarisation. Ainsi, pour une tension V₂ de l'ordre de 8 volts, chacun des transistors ne verra jamais plus que la tension V₁.

Il est désormais possible d'intégrer, dans un même circuit, les circuits de traitement audio basse tension et d'amplification sous une tension supérieure en utilisant la technologie des circuits basse tension. Les modes de réalisation décrits ci-dessus montrent qu'une telle intégration peut s'effectuer sans engendrer de distorsion dans le signal et avec une augmentation de surface acceptable. Cette augmentation de surface est de toute façon négligeable par rapport à la surface requise, sur une carte électronique, par deux circuits distincts. En outre, cela permet de réduire le coût.

Divers modes de réalisation ont été décrits, diverses variantes et modifications apparaîtront à l'homme de l'art. En particulier, les dimensions à donner aux transistors dépendent des courants de sortie fixés par l'application. De même, les éléments résistifs et capacitifs sont aisément déterminables par l'homme du métier à partir des indications fonctionnelles données ci-dessus et de l'application.

En outre, bien que l'invention ait été décrite en relation avec un exemple d'amplificateur pour signaux audio, elle s'applique plus généralement dès que des problèmes similaires se posent, par exemple, pour l'amplification d'un signal analogique là où l'on souhaite pouvoir intégrer, dans un même circuit, des éléments basse tension et des éléments haute tension dans la technologie basse tension.

Enfin, bien que l'invention ait été décrite en relation avec des tensions d'alimentation positives par rapport à la masse, elle se transpose à une application où le signal à amplifier est de polarité négative par rapport à la masse. La structure de l'étage de sortie reste identique en appliquant la masse sur la borne 8 et la tension négative sur la borne 7. La structure de l'étage d'entrée est quant à elle différente pour respecter la fourniture d'un signal V_{IN} négatif par rapport à la masse. La transformation d'un tel étage d'entrée différentiel en remplaçant les transistors à canal P par des transistors à canal N et inversement pour appliquer, sur le transistor N25, une tension négative est à la portée de l'homme du métier.

## Revendications

1. Etage de sortie d'un amplificateur classe A intégré dans une technologie adaptée à une première tension (V₁) et destiné à être alimenté sous une deuxième tension (V₂) supérieure à la première, comportant :
un ou plusieurs transistors (P41, DP42) d'un premier type de canal (P) entre une première borne (8) d'application de la deuxième tension et une borne (9) de sortie de l'étage ;
des transistors (N25, N31, N32, N33) d'un deuxième type de canal (N) entre cette borne de sortie (9) et une deuxième borne (7) d'application de la deuxième tension, dans lequel :
un premier transistor (N25) du deuxième type de canal a sa grille directement connectée à une borne (24) d'entrée de l'étage ;
au moins un deuxième (N31) et un troisième (N32) transistors du deuxième type de canal sont en série entre la borne de sortie et ledit premier transistor, la grille du deuxième transistor étant connectée au point milieu d'un pont diviseur résistif (R1, R2) entre ladite borne de sortie et la grille du troisième transistor, et la grille du troisième transistor étant polarisée à un potentiel fixe (V_{G32}).

2. Etage de sortie selon la revendication 1, dans lequel deux éléments capacitifs (C1, C2) en série relient la borne d'entrée (24) à la borne de sortie (9), un pont diviseur résistif (R3, R4) reliant la borne de sortie à la deuxième borne (7) d'application de la deuxième tension (V₂) et ayant son point milieu relié au point milieu de l'association en série des deux éléments capacitifs.

3. Etage de sortie selon la revendication 1 ou 2, dans lequel un quatrième transistor (N33) du deuxième type de canal (N) est intercalé entre les premier (N25) et troisième (N32) transistors.

4. Etage de sortie selon l'une quelconque des revendications 1 à 3, dans lequel le ou les transistors du premier type de canal (P) forment une source de courant entre ladite première borne (8) d'application de la deuxième tension (V₂) et la borne de sortie (9).

5. Etage de sortie selon la revendication 4, dans lequel ladite source de courant comporte au moins un premier transistor (DP42) du premier type de canal (P), de type DRIFT.

6. Etage de sortie selon la revendication 5, dans lequel ledit premier transistor (DP42) du premier type de canal (P) est monté en cascode avec au moins un deuxième transistor (P41) du même type.

7. Etage de sortie selon la revendication 4, dans lequel plusieurs transistors (P41, P53, P54, P55) du premier type de canal (P) sont en série entre la première borne (8) d'application de la deuxième tension (V₂) et la borne de sortie (9), au moins un (P55) de ces transistors ayant sa grille reliée au point milieu d'un pont diviseur résistif (R5, R6) connecté entre la grille du transistor voisin de l'association en série et la borne de sortie (9).

8. Amplificateur classe A, comportant un étage de sortie conforme à l'une quelconque des revendications 1 à 7.

9. Chaîne de traitement de signaux audio comportant, pour chaque voie, un amplificateur selon la revendication 8.
